# EUROPÄISCHE PATENTANMELDUNG

(11) **EP 0 594 032 A1**
(43) Veröffentlichungstag der Anmeldung: **27.04.1994**
(21) Anmeldenummer: 93116460.2
(22) Anmeldetag: 12.10.1993
(51) Int. Cl.: C23C 16/52, C23C 16/18, C23C 16/50

(54) **Abscheidung von Schichten mit hoher spezifischer elektrischer Leitfähigkeit**

(30) Priorität: 21.10.1992 DE 4235358; 24.06.1993 DE 4320931
(71) Anmelder: Solvay Deutschland GmbH, D-30173 Hannover (DE)
(72) Erfinder: Hamerich, Andreas, D-25335 Elmshorn (DE); Müller, Jörg, D-21244 Buchholz (DE); Lottermoser, Lars, D-27419 Klein-Meckelsen (DE); Döllein, Günther, D-30627 Hannover (DE)
(74) Vertreter: Lauer, Dieter, Dr.

(57) **Zusammenfassung**

Beschrieben wird ein Verfahren zur Abscheidung Metall enthaltender Schichten hoher spezifischer elektrischer Leitfähigkeit unter Zersetzung metallorganischer Verbindungen in wasserstoffhaltiger Gas- oder Dampfphase mittels eines Plasmas. Dabei wird unter Aufnahme eines OES-Spektrums die Energiedichte des Plasmas optimiert. Es lassen sich so z.B. festhaftende Leiterbahnen erzeugen, deren Breite kleiner als 50 nm ist und deren Verhältnis von Höhe zu Breite größer 1 ist. Offenbart wird ferner ein Verfahren zur Optimierung der Abscheidung von Metall enthaltenden Schichten mit hoher spezifischer Leitfähigkeit sowie ein bei dem erfindungsgemäßen Verfahren erhältlicher Verbundkörper aus Polymer und Metallschicht.

## Beschreibung

Die Erfindung bezieht sich auf ein Verfahren zur Abscheidung von Metall enthaltenden Schichten hoher spezifischer elektrischer Leitfähigkeit unter Zersetzung metallorganischer Verbindungen in wasserstoffhaltiger Gas- oder Dampfphase mittels eines Plasmas.

Es ist bekannt, Substrate durch Oberflächenbeschichtung so zu modifizieren, daß ihre Oberfläche bestimmte funktionale Eigenschaften aufweist. Beispielsweise kann man spiegelnde Metallschichten auf Substrate aufbringen, Schichten, die den elektrischen Strom leiten, Schichten, die die Oberfläche des Substrats härten oder gegen Verschleiß schützen, Schichten, die die Haftfähigkeit weiterer Schichten verbessern usw. Die Abscheidung von Schichten, die beispielsweise Kupfer in metallischer Form enthalten, ermöglicht die Erzeugung für den elektrischen Strom leitfähiger Leiterbahnen auf nichtleitenden Substraten, beispielsweise auf Keramik oder organischen Polymeren.

Die Abscheidung dünner Metallschichten gelingt beispielsweise nach dem bekannten CVD-Verfahren. Dabei werden metallorganische Verbindungen verdampft. Die Zersetzung unter Bildung Metall enthaltender Schichten kann beispielsweise thermisch oder plasmainduziert bewirkt werden. Ein plasmaunterstütztes CVD-Verfahren (PECVD-Verfahren) zur Abscheidung von Kupfer beschreiben N. Awaya und Y. Arita in Jap. J. Appl. Phys. 30 (1991), Seiten 1813 bis 1817. Dabei wurde Kupfer-acetylacetonat in einen Parallelplatten-Plasmareaktor eingebracht und zersetzt. Die abgeschiedenen Kupfer-Schichten wurden auf ihre Leitfähigkeit hin untersucht. Es wurde festgestellt, daß der geringste spezifische Widerstand der Kupfer-Schichten bei einer Substrattemperatur zwischen 200 °C und 280 °C auftrat. Bei Abscheidetemperaturen unterhalb von 100 °C war der Widerstand so hoch, daß er nicht vermessen werden konnte.

Aufgabe der vorliegenden Erfindung ist es, ein Verfahren zur Abscheidung von Metall enthaltenden Schichten hoher spezifischer elektrischer Leitfähigkeit anzugeben, welches auf einfache Weise die gezielte Abscheidung von Schichten besonders hoher spezifischer elektrischer Leitfähigkeit gestattet. Diese Aufgabe wird durch das erfindungsgemäße Verfahren gelöst.

Das erfindungsgemäße Verfahren zur Abscheidung von Metall enthaltenden Schichten hoher spezifischer elektrischer Leitfähigkeit unter Zersetzung metallorganischer Verbindungen in wasserstoffhaltiger Gas- oder Dampfphase mittels eines Plasmas, ist dadurch gekennzeichnet, daß man ein OES-Spektrum der durch Plasma angeregten Gas- oder Dampfphase aufnimmt und die Energiedichte des Plasmas derart einregelt, daß das Verhältnis eines nicht einem Fragment eines Liganden des Metalls zugeordneten Peaks (Nicht-Ligandenfragment) zu einem, einem Fragment eines Liganden zugeordneten Peaks (Liganden-Fragment) mindestens so groß ist wie das entsprechende Verhältnis, wie es bei Abscheidung einer Metallschicht aufgenommen wird, welche maximal 200 % des spezifischen elektrischen Widerstands des Bulkmaterials aufweist.

Beispielsweise kann man die Fläche zweier Peaks, die Halbwertsbreite oder vorzugsweise die Peakhöhe ins Verhältnis setzen.

Das OES(Optical Emission Spectroscopy)-Spektrum wird am einfachsten mit einem OES-Spektrometer im rechnergesteuerten Betrieb an einem Fenster des Plasma-Reaktors vorgenommen.

Bei dem Peak, der einem Nicht-Ligandenfragment zugeordnet wird, kann es sich beispielsweise um einen Metallpeak, einen Peak des Liganden oder einen Metallhydrid-Peak handeln.

Das erfindungsgemäße Verfahren kann zur Zersetzung von metallorganischen Verbindungen mit σ- und/oder π-Bindung zwischen Metall und Ligand bzw. Liganden verwendet werden. Beispielsweise kann man metallorganische Verbindungen zersetzen, die Metall-Kohlenstoff-Bindungen aufweisen, beispielsweise Metall-Alkyl-, Metall-Alken-, Metall-Aryl-, Metall-Aren- und/oder Metall-Carbonyl-Gruppen aufweisen. Metallorganische Verbindungen mit Metall-Heteroatom-Bindungen können ebenfalls eingesetzt werden. Beispielsweise kann man Verbindungen einsetzen, deren Liganden über Stickstoff mit dem Metall verbunden sind, beispielsweise Metall-Ketiminato-Komplexe. Besonders gut geeignet ist das Verfahren zur Zersetzung von metallorganischen Verbindungen, welche Metall-Sauerstoff-Bindungen aufweisen, vorzugsweise Verbindungen, in denen das Metall durch eine oder mehrere β-Diketonat-Gruppen komplexiert ist. Sehr gut geeignet ist das Verfahren zur Zersetzung von metallorganischen Verbindungen von Halbedelmetallen, besonders Kupfer, und Edelmetallen, besonders von Silber, Gold sowie Platingruppenmetallen.

Hervorragend eignet sich das erfindungsgemäße Verfahren zur Zersetzung von Verbindungen, in welchen das Metall Kupfer ist, welches mit β-Diketonaten ausgewählt aus der Gruppe umfassend β-Diketonate mit 5 bis 11 C-Atomen und β-Diketonate mit 5 bis 11 C-Atomen, substituiert durch 1 bis 18 Halogenatome, vorzugsweise substituiert durch 1 bis 6 Fluoratome, komplexiert ist. Besonders gut verwendbare Verbindungen sind Kupfer-acetylacetonat, Kupfer-heptandionat, Kupfer-dimethylheptandionat und Kupfer-tetramethylheptandionat. Gut geeignet ist auch Kupfer-hexafluoracetylacetonat und Kupfer-trifluoracetylacetonat.

Auch durch organische Reste substituierte Molybdän- bzw. Wolfram-Carbonyle, z. B. die in der DE-OS 41 36 321 beschriebenen, sind mit guten Abscheidungsergebnissen im erfindungsgemäßen Verfahren einsetzbar. Es handelt sich um Verbindungen der Formel M R¹R²(CO)₃. Darin bedeutet M Molybdän oder Wolfram, R¹ ist z.B. Cyclopentadienyl oder durch C1-C3-Alkylgruppen substituiertes Cyclopentadienyl, R² ist z.B. C1-C5-Alkyl; C2-C5-Alkenyl; C1-C3-Alkoxy; Phenyl oder substituiertes Phenyl; Heteroaryl. Sehr gut geeignete Verbindungen sind z.B. Mo(C₅H₅) (CH₃) (CO)₃, W(C₅H₅) (CH₃) (CO)₃, Mo(C₅H₅) (C₂H₅) (CO)₃, oder W(C₅H₅) (C₂H₅) (CO)₃. Die Herstellung solcher Verbindungen ist bekannt und wird in der DE-OS 41 36 321 beschrieben. (CH₃) (C₅H₅)W(CO)₃ z.B. kann man herstellen, indem man C₅H₅Na mit W(CO)₆ umsetzt und das resultierende Na-Salz des (Tricarbonyl-Cyclopentadienyl)wolframats mit Methyliodid umsetzt.

Als Plasma setzt man vorzugsweise ein kapazitiv eingekoppeltes RF-Plasma ein.

Vorzugsweise induziert man die Zersetzung mit einem frequenten Plasma, vorzugsweise einem Hochfrequenz (RF)-Plasma, im Bereich von 3 bis 30 MHz. Üblicherweise arbeitet man mit einer Frequenz von 13,56 MHz.

Die Abscheidung kann in üblichen Plasma-CVD-Apparaturen durchgeführt werden. Solche Apparaturen weisen einen evakuierbaren Rezipienten (Reaktor) und eine, zwei oder gewünschtenfalls auch mehr Elektroden auf. Die im erfindungsgemäßen Verfahren bei der Einregelung der Plasma-Energiedichte zu verwendenden Apparaturen weisen außerdem ein Fenster zur Aufnahme des OES-Spektrums auf. Weiterhin können übliche Bauteile, wie Leitungen zur Zuführung von Gasen, der metallorganischen Verbindung, Anschlüsse zur Erzeugung des Vakuums, Meßfühler zur Messung der Temperatur des Substrats, der Elektroden, der Reaktorwand, Meßfühler zur Messung des Vakuums etc. vorhanden sein.

Besonders gut geeignet sind Apparaturen mit einer Elektrode (die andere Elektrode wird durch die Reaktorwand gebildet) oder Apparaturen mit parallel angeordneten Elektroden ("Parallelplatten-Reaktor"). Die Elektrode bzw. eine der beiden Elektroden wird an den Frequenzgenerator angeschlossen, die andere Elektrode bzw. die Reaktorwand wird zweckmäßig elektrisch isoliert oder auf Masse gelegt. Gewünschtenfalls kann man das Gleichspannungspotential der Kathode gegen Masse durch eine Bias-Spannung verändern, wodurch die Abscheidung und die Eigenschaften der abgeschiedenen Metallschicht, besonders bei niedriger Substrattemperatur, modifiziert werden können.

Gemäß einer Variante der Erfindung scheidet man anodisch ab. Man bringt dabei das zu beschichtende Substrat in die Nähe der auf Masse gelegten oder elektrisch isolierten Anode, die gewöhnlich größer ist als die Kathode. Um metallische Schichten besonders hoher Haftfestigkeit zu erhalten, kann man das Substrat, z.B. anorganische Materialien wie Keramik, Glas, oder organische Materialien wie Polymere, z.B. Kunststoffe, vorbehandeln, z.B. durch eine Plasma-Behandlung ("Vorsputtern"). Man kann auch eine chemische Vorbehandlung vornehmen. Eine solche Vorbehandlung mit organischen Verbindungen wird in der WO 92/15723 beschrieben.

Gemäß einer anderen Variante, die besonders vorteilhafte Ergebnisse zeigt und deshalb bevorzugt ist, scheidet man kathodisch ab. Dabei bringt man das zu beschichtende Substrat in die Nähe der mit dem Frequenzgenerator verbundenen Kathode. Das Verfahren gelingt besonders gut, wenn das Flächenverhältnis von Kathode zur Anode größer als 2:1, vorzugsweise größer als 4:1 ist. Mit dieser Verfahrensvariante kann man anorganische Materialien, die üblicherweise als Substrat verwendet werden, z.B. Halbleiter, Isolatoren, Keramik, Glasphasen, Kohlenstoff, insbesondere Kohlenstoffasern, beschichten. Besonders gut geeignet ist diese Variante zur Beschichtung von organischen Polymeren. Aus der Metallschicht und den Polymeren, z.B. Kunststoffen, wie Epoxidharz, glasfaserverstärktem Epoxidharz, Polyamid, Polyimid, Polyethylen, Polypropylen, Polyphenylensulfid, halogenhaltigen Polymeren bildet sich ein Verbundkörper aus Polymer und der Metallschicht mit besonders guten Eigenschaften, insbesondere in bezug auf die Haftfestigkeit der Metallschicht. Auch bei der kathodischen Abscheidung kann man das Gleichspannungspotential der Kathode gegen Masse durch eine Bias-Spannung verändern, um die Schichtbildung bzw. die Eigenschaften der abgeschiedenen Schicht zu modifizieren. Die Variante mit kathodischer Abscheidung ist besonders deshalb vorteilhaft, weil, besonders auf organischen Polymeren, fest haftende Metallschichten erzeugt werden können, ohne daß eine haftungsverbessernde Vorbehandlung des Substrats nötig ist. Außerdem kann man mit sehr hoher Schichtbildungsrate abscheiden, bis hin zu 10 nm/min und mehr. Eine solch hohe Abscheidegeschwindigkeit hochleitfähiger Schichten bei der Abscheidung z.B. von Kupfer unter Verwendung von Kupfer-acetylacetonat bzw. Kupfer-hexafluoracetylacetonat bei derart niedrigen Substrattemperaturen (100 °C) ist im Stand der Technik bislang nicht bekannt geworden.

Natürlich gelingt die Abscheidung auch in Plasma-Apparaturen mit Elektroden mit gleichem Potential.

Die zu verdampfende metallorganische Verbindung wird, im Rezipienten oder in einer separaten Einrichtung, zweckmäßig in einem Verdampfer auf eine Temperatur gebracht, bei der der gewünschte Dampfdruck erreicht wird. Die Substrattemperatur und/oder Wandtemperatur liegt vorteilhafterweise mindestens um 5 °C höher als die Temperatur der in die Gas- oder Dampfphase zu überführenden metallorganischen Verbindung im Verdampfer. Bevorzugt liegt die Substrattemperatur und/oder Wandtemperatur 5 bis 25 °C höher als die Temperatur der Verbindung im Verdampfer. Die Substrattemperatur liegt bevorzugt im Bereich von Raumtemperatur bis 120 °C. Auch bei höheren Temperaturen können noch befriedigende Ergebnisse erzielt werden. Der Druck im Rezipienten liegt vorteilhafterweise oberhalb von 100 mTorr. Beste Ergebnisse werden bei einem Rezipienten-Druck von bis zu 5 Torr erhalten. Dabei ist anzumerken, daß der optimale Bereich bezüglich Substrattemperatur und Gasdruck im Rezipienten von der jeweils verwendeten Metallverbindung abhängt. Gegebenenfalls kann man entsprechende Handversuche zur Ermittlung der optimalen Bedingungen durchführen. Bei Kupferverbindungen, wie Kupfer-acetylacetonat beispielsweise liegt die optimale Temperatur im Bereich von Raumtemperatur bis 120 °C und der Druck im Bereich von 500 mTorr bis 3 Torr.

Das Prozeßgas besteht vorzugsweise aus Wasserstoff. Man kann aber gewünschtenfalls einen Teil des Wasserstoffs, bis hin zu 80 Vol.-%, durch Inertgase wie Edelgase, z.B. Argon oder Xenon, ersetzen.

Mit dem erfindungsgemäßen Verfahren, insbesondere bei kathodischer Abscheidung, kann man Metallschichten einer Dicke von 2000 nm und mehr abscheiden. Es gelingt, Schichten mit einem spezifischen Widerstand von maximal 200 % Bulkmaterials, vorzugsweise 130 % und weniger, abzuscheiden. Besonders bevorzugt kann mit dem Verfahren Metallschichten, insbesondere Kupferschichten, einer Dicke von 200 bis 2000 nm und einem spezifischen Widerstand von maximal 200 % des Bulkmaterials erzeugen. Dies gelingt insbesondere mit der kathodischen Abscheidung sehr schnell, da selbst bei niedrigen Temperaturen überraschenderweise eine hohe Abscheidegeschwindigkeit, von beispielsweise mehr als 2 nm/min, bis hin zu 10 nm/min und mehr möglich ist.

Ein weiterer Gegenstand der Erfindung liegt in der Bereitstellung eines Verfahrens zur Optimierung der Abscheidung von Metall enthaltenden Schichten mit einem spezifischen Widerstand von maximal 200 % des spezifischen elektrischen Widerstands des Bulkmaterials. Das erfindungsgemäße Verfahren sieht vor, daß man zur Optimierung der Abscheidung von Metall enthaltenden Schichten mit einem spezifischen Widerstand, der maximal 200 % des spezifischen elektrischen Widerstands des Bulkmaterials beträgt, unter Zersetzung einer metallorganischen Verbindung in wasserstoffhaltiger Gas- oder Dampfphase mittels eines Plasmas, bezüglich der Energiedichte des Plasmas unter Bedingungen arbeitet, die wie folgt ermittelt werden können:
a) Man führt die Zersetzung bei einer Energiedichte des Plasmas durch, die mindestens so hoch ist, daß Liganden der zu zersetzenden metallorganischen Verbindung in Fragmente zerschlagen werden.
b) Man mißt das OES-Spektrum und bestimmt Peaks, die nicht auf ein Fragment des Liganden (Nicht-Ligandenfragment) zurückzuführen sind sowie solche, die auf ein bestimmtes Fragment des Liganden zurückzuführen sind.
c) Man optimiert den spezifischen Widerstand der abgeschiedenen Schicht durch Verringerung der in a) eingestellten hohen Energiedichte, bis im OES-Spektrum ein nicht dem Liganden zugeordneter Peak und der dem Fragment des organischen Molekülteils zugeordnete Peak ein solches Mindestverhältnis aufweisen, welches den gewünschten Anforderungen an die Leitfähigkeit der abgeschiedenen Schicht entspricht.
Prozeßdruck und Abscheidetemperatur werden zunächst fest gewählt, z. B. 650 mTorr und 100 °C.

Ein weiterer Gegenstand der Erfindung sind Metallschichten einer Dicke von 200 bis 2000 nm und einem spezifischen Widerstand von maximal 200 % des Bulkmaterials, wie sie nach dem Verfahren der Erfindung erhältlich sind. Besonders bevorzugt sind Kupferschichten.

Noch ein weiterer Gegenstand sind Verbundkörper aus Polymer, gegebenenfalls einer oder mehreren Zwischenschichten und einer Metallschicht einer Dicke von 200 bis 2000 nm sowie einem spezifischen Widerstand von maximal 200 % des Bulkmaterials. Solche Verbundkörper sind beim erfindungsgemäßen Verfahren erhältlich. Sie zeichnen sich durch eine sehr hohe Stabilität und Haftung der Metallschicht auf dem Polymer aus. Besonders bevorzugt sind Verbundkörper von Kupfer/Epoxidharz, Kupfer/Polyimid, Kupfer/Polyamid, Kupfer/Polyethylen und Kupfer/Polypropylen. Bei den Zwischenschichten, die gegebenenfalls im Verbundkörper enthalten sein können, handelt es sich ggf. um nach bekannten Verfahren erzeugte Zwischenschichten. Hierzu gehören beispielsweise Schichten, die die Oberfläche vergüten sollen, beispielsweise gegen Reibverschleiß, zur Haftvermittlung. Beispielhaft erwähnt seien Schichten aus Titannitrid und Bornitrid.

Besonders vorteilhafte Eigenschaften weisen Verbundkörper aus Polymer auf, welche eine Metallschicht in Form einer Leiterbahn aufweisen. Derartige Verbundkörper gehören ebenfalls zur Erfindung. Sie sind dadurch erhältlich, daß man auf dem Polymer entsprechend dem erfindungsgemäßen Verfahren zunächst eine erste Metallschicht abscheidet. Dann wird auf die erste Metallschicht eine Deckschicht aufgebracht. Hierzu kann man z.B. eine Lackschicht als Deckschicht aufschleudern, deren Dicke variabel ist, z.B. 10 µm oder mehr betragen kann. Die Lackschicht wird dann photolithographisch strukturiert. Beispielsweise kann man Bahnen einer Breite von 10 µm erzeugen, kleinere Strukturen sind ebenfalls möglich. Anschließend scheidet man zur Bildung von Leiterbahnen galvanisch eine zweite Metallschicht ab. Zweckmäßig soll die zweite Metallschicht nicht wesentlich dicker als die Lackschicht sein. Die Deckschicht wird dann entfernt z.B. durch geeignete Lösungsmittel, wie Aceton. Dabei wird die erste Metallschicht, die nach dem erfindungsgemäßen Verfahren aufgetragen worden war, wieder freigelegt. Die freigelegte Metallschicht wird weggeätzt, z.B. mittels geeigneter Säuren oder saurer Verbindungen.

Zwischen Polymer (eine Aufzählung geeigneter Polymere siehe oben) und Metallschicht bzw. Deckschicht können gegebenenfalls noch eine oder mehrere Zwischenschichten vorgesehen sein, beispielsweise den elektrischen Strom isolierende oder die Haftung einzelner Schichten verbessernde Zwischenschichten.

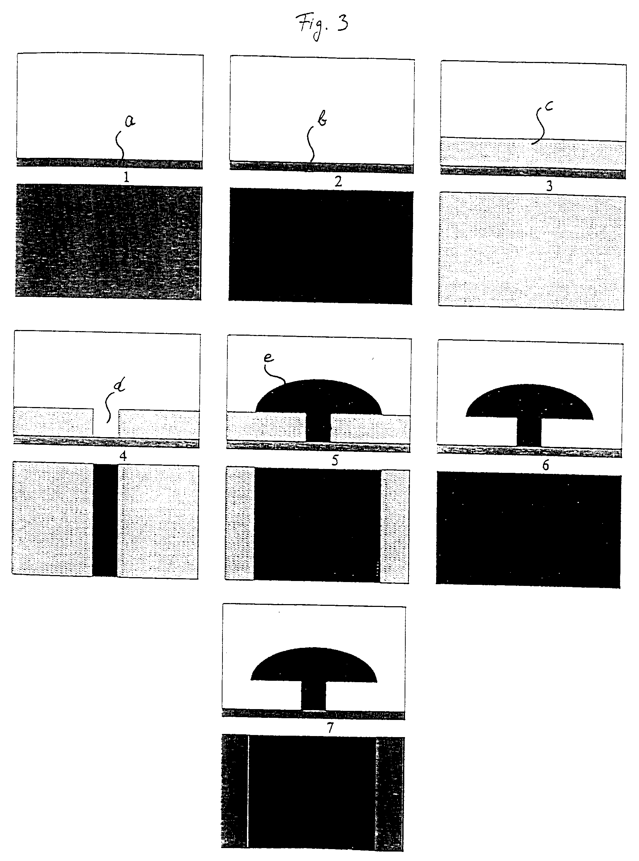

Das Verfahren zur Herstellung von Leiterbahnen wird unter Zuhilfenahme der Figur 3 weiter erläutert. Die Fig. 3 besteht aus 7 Bilddarstellungen, die jeweils zwei, paarweise zueinander gehörige Abbildungen aufweisen. Die obere Abbildung stellt einen Querschnitt durch die Leiterplatte (Platine) dar, die untere Abbildung jeweils die Draufsicht. Das Platinenmaterial ist schraffiert dargestellt, die Lackschicht durch Punkte angedeutet, die erste Metallschicht bzw. die Leiterbahn darstellende zweite Metallschicht durchgehend schwarz.

Auf die Platine a (beispielsweise glasfaserverstärktes Epoxid-Harz) in Darstellung 1 der Fig. 3 wird erfindungsgemäß die Metallschicht b abgeschieden. Auf den entstehenden Verbundkörper, siehe Darstellung 2, wird eine Lackschicht c aufgeschleudert, Ergebnis siehe Darstellung 3. Durch photolithographische Strukturierung werden bestimmte Bereiche d der Lackschicht entfernt, so daß der in Darstellung 4 wiedergegebene Verbundkörper entsteht. Anschließend galvanisiert man selektiv über den Bereichen d eine Metallschicht e auf (die pilzartige Struktur der Metallschicht e in den Darstellungen 5, 6 und 7 kann durch Variation der Abscheidebedingungen, insbesondere der Abscheidedauer, modifiziert werden, so daß die Metallschicht e auch nur wenig oder gar nicht über die Lackschicht c hinausragen kann). Anschließend wird zunächst die Lackschicht c und dann die freiliegende Metallschicht b auf der Platine a entfernt. Es bleibt dann der Leiterbahnen aufweisende Verbundkörper übrig.

Besonders bevorzugte, Leiterbahnen aufweisende Verbundkörper weisen als erste Metallschicht eine Wolfram-, Molybdänoder insbesondere Kupfer-Schicht auf. Mechanisch besonders belastbare Verbundkörper entstehen bei kathodischer Abscheidung der ersten Metallschicht. Die die Leiterbahnen darstellende zweite Metallschicht ist vorzugsweise eine Kupfer-Schicht.

Die Breite der Leiterbahnen ist vorzugsweise kleiner als 50 nm, insbesondere kleiner als 30 nm, ganz besonders bevorzugt kleiner als 10 nm. Das Verhältnis von Höhe zu Breite der Leiterbahnen kann variieren, je nach Art der photolithographischen Bearbeitung. Vorzugsweise beträgt das Verhältnis von Höhe zu Breite der Leiterbahnen mehr als 1, z.B. bis hin zu 10 oder mehr.

Das erfindungsgemäße Verfahren bietet den bislang nicht bekannten Vorteil, daß man bei niedriger Abscheidetemperatur gezielt und mit gleichbleibender Qualität mit hoher Abscheidegeschwindigkeit Metallschichten abscheiden kann, die sich durch hohe Haftfestigkeit und geringen spezifischen elektrischen Widerstand auszeichnen. Dies wird besonders bei den Verbundkörpern mit Leiterbahnen deutlich: die kathodisch abgeschiedene Schicht ist derart haftfest, daß provozierte Bruchkanten im Schichtmaterial der galvanisch abgeschiedenen Schicht und nicht im Bereich der erfindungsgemäß abgeschiedenen Schicht liegen.

Die Erfindung wird anhand von Beispielen erläutert, ohne sie in ihrem Umfang einzuschränken.

Bei den Peaks "A", "B" und "C" handelt es sich in den verschiedenen Beispielen um die gleichen Liganden-Fragmente bzw. Nicht-Liganden-Fragmente.

### Beispiel 1:

### Abscheidung einer Kupfer-Schicht auf Polyimid.

### 1.1. Verwendete Apparatur:

Verwendet wurde eine Plasma-Apparatur mit einer Substrat-Elektrode. Ihr Durchmesser betrug 78 mm. Der Durchmesser der "Gegenelektrode", dargestellt durch den Rezipienten-Deckel, betrug 156 mm; die Rezipienten-Innenwände stellen zusätzliche effektive Gegenelektrodenflächen dar. Das Flächenverhältnis von Sübstratelektrode zu auf Masse gelegter Gegenelektrode war insgesamt größer als 4:1. Der Elektrodenabstand konnte im Bereich von 30 bis 80 mm variiert werden. Die Druckmessung erfolgte mit einem "Baratron" (Kapazitätsmanometer). Als Leistungsquelle wurde ein RF-Generator mit einer Sendefrequenz von 13,56 MHz verwendet, dessen Leistung im Bereich von 0 bis 300 W geregelt werden konnte. Die Substratheizung konnte im Bereich von 20 bis 500 °C variiert werden. Ein OES-Spektrometer im rechnergesteuerten Betrieb konnte durch ein Fenster am Rezipienten Spektren des Plasmaraumes erstellen.

### 1.2. Durchführung der Abscheidung:

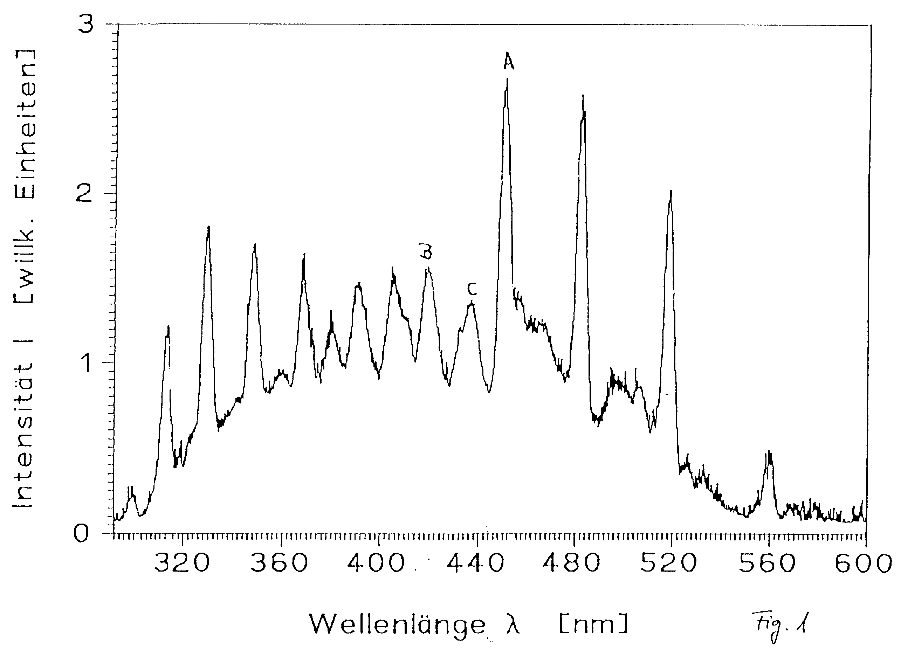

Die Substratelektrode wurde mit dem Frequenzgenerator verbunden, dessen Leistung auf 40 W eingestellt wurde. Als Precursor wurde Kupfer(II)-acetylacetonat in einen, im Rezipienten befindlichen Verdampfer eingebracht und dort auf 115 °C erhitzt. Als Substrat wurde Glas verwendet und auf eine Temperatur von 120 °C gebracht. Prozeßgas war Wasserstoff, der Gesamtdruck im Rezipienten betrug 1000 mTorr. Die Abscheidung wurde über eine Dauer von 26 Minuten durchgeführt.
Die Schichtdicke der abgeschiedenen Schicht betrug 125 nm, die durchschnittliche Aufwachsrate somit 4,8 nm/min. Die Leitfähigkeit wurde über eine sogenannte "4-Punkt-Messung" nach van der Pauw, Philips Res. Repts. Vol. 13, Seiten 1-9 (1958) durchgeführt. Der spezifische elektrische Widerstand wurde zu 2,2 bis 2,3 µΩcm bestimmt, das sind etwa 130 % des Wertes für Bulk-Kupfer.
Während der Durchführung des Abscheideverfahrens wurde ein OES-Spektrum aufgenommen, das in Fig. 1 wiedergegeben ist.
Bei dem mit dem "B" gekennzeichneten Peak handelt es sich um das Signal eines Nicht-Ligandenfragments. Die mit "A" und "C" gekennzeichneten Peaks werden auf das Ligandenfragment "Kohlenmonoxid" zurückgeführt. Das Intensitätsverhältnis (bez. auf die Peak-Höhe) B/A beträgt 0,379, das Intensitätsverhältnis B/C beträgt 1,333.

### Beispiel 2:

### Kathodische Abscheidung auf Polyimidfolie.

Beispiel 1 wurde wiederholt. Dieses Mal wurde als Substrat eine Polyimidfolie (Ursprung: Firma Du Pont, USA) eingesetzt. Die Ergebnisse entsprachen denen des Beispiels 1.

### Beispiel 3:

### Kathodische Abscheidung einer nicht leitfähigen Schicht.

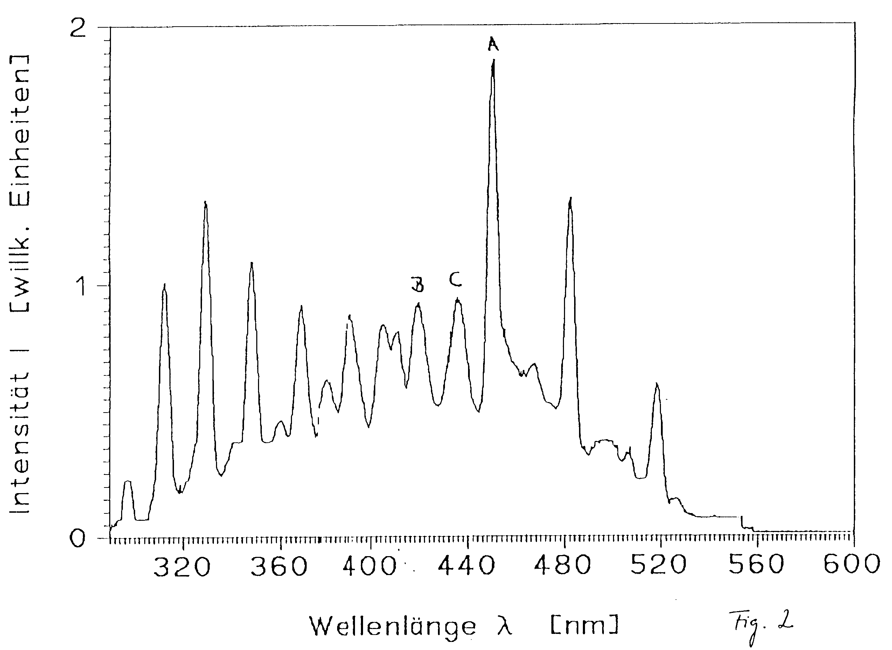

Beispiel 1 wurde wiederholt. Die Leistung des Frequenzgenerators wurde auf 90 W eingeregelt, als Substrat wurde wiederum Glas verwendet, die Prozeßdauer betrug 12 min. Die abgeschiedene Schicht erwies sich als nicht leitfähig. Ein während der Abscheidung aufgenommenes OES-Spektrum wird in Figur 2 wiedergegeben. Der mit "B" gekennzeichnete Peak wird einem Nicht-Ligandenfragment zugeordnet, während die mit "A" und "C" gekennzeichneten Peaks einem Ligandenfragment, nämlich Kohlenmonoxid, zugeordnet werden. Das Intensitätsverhältnis der Peaks B/A beträgt 0,167, das Intensitätsverhältnis der Peaks B/C beträgt 0,781.
Die Beispiele belegen, daß es möglich ist, durch Aufnahme von OES-Spektren und Vergleich bestimmter Peaks miteinander, die einzustrahlende RF-Leistung zur Erzielung einer optimalen Leitfähigkeit der abgeschiedenen Schicht einzuregeln.

### Beispiel 4:

### Anodische Abscheidung

In diesem Beispiel wurde die Substratelektrode auf Masse gelegt und in den Rezipienten-Deckel eine Gegenelektrode eingeführt und mit dem Frequenzgenerator verbunden. Der Frequenzgenerator wurde auf eine Leistung von 10 W eingeregelt. Der Druck in der Apparatur betrug 628 mTorr, als Prozeßgas wurde ein Gemisch von Argon und Wasserstoff verwendet. Als Substrat diente eine Scheibe aus Siliciumnitrid. Die Prozeßdauer betrug 150 min.
Die abgeschiedene Schichtdicke betrug 57 nm, die Leitfähigkeit betrug 3,02 µΩcm (gemessen nach der 4-Punkt-Methode).
Das Beispiel belegt, daß auch anodisch gut leitfähige Schichten abgeschieden werden können.

### Beispiel 5:

### Herstellung von Wolframschichten

Eingesetzt wurde Methyl-tricarbonyl-cyclopentadienyl-wolfram, das gemäß Beispiel 1 der DE-OS 41 36 321 durch Umsetzung von W(CO)₆ mit C₅H₅-Na und Weiterreaktion mit Methyliodid erhalten worden war.
Die kathodische Abscheidung gemäß Beispiel 1 lieferte leitfähige Wolfram-Schichten.

### Beispiel 6:

### Herstellung einer Leiterbahnen aufweisenden Platine.

Eingesetzt wurde Standard-Platinenmaterial (glasfaserverstärktes Epoxid-Harz). Gemäß Beispiel 1 wurde unter Verwendung von Kupfer-hexafluoracetylacetonat eine fest haftende erste Metallschicht einer Dicke von 0,1 µm abgeschieden. Auf diese Schicht wurde eine Lackschicht einer Dicke von 10 µm aufgeschleudert und photolithographisch strukturiert (dabei wurden selektiv bahnartige Bereiche der ersten Metallschicht freigelegt). Galvanisch wurde eine Kupfer-Schicht einer Dicke von 25 µm auf diesen Bahnen abgeschieden. Die Lackschicht wurde mittels Aceton abgelöst und der Verbundkörper zur Ablösung der freiliegenden ersten Kupferschicht naßchemisch geätzt. Es resultiert eine Platine mit sehr fest haftenden Leiterbahnen.

## Patentansprüche

1. Verfahren zur Abscheidung von Metall enthaltenden Schichten hoher spezifischer elektrischer Leitfähigkeit unter Zersetzung metallorganischer Verbindungen in wasserstoffhaltiger Gas- oder Dampfphase mittels eines Plasmas, dadurch gekennzeichnet, daß man ein OES-Spektrum der durch Plasma angeregten Gas- oder Dampfphase aufnimmt und die Energiedichte des Plasmas derart einregelt, daß das Verhältnis eines nicht einem Fragment eines Liganden des Metalls zugeordneten Peaks (Nicht-Ligandenfragment) zu einem, einem Fragment eines Liganden zugeordneten Peaks mindestens so groß ist wie das entsprechende Verhältnis, wie es bei Abscheidung einer Metallschicht aufgenommen wird, welche maximal 200 % des spezifischen elektrischen Widerstands des Bulkmaterials aufweist.

2. Verfahren nach Anspruch 1, dadurch gekennzeichnet, daß man als metallorganische Verbindungen solche Verbindungen einsetzt, welche Metall-Sauerstoff-Bindungen aufweisen.

3. Verfahren nach Anspruch 1 oder 2, dadurch gekennzeichnet, daß man Verbindungen einsetzt, in denen das Metall durch eine oder mehrere β-Diketonat-Gruppen komplexiert ist.

4. Verfahren nach Anspruch 1 bis 3, dadurch gekennzeichnet, daß man Verbindungen einsetzt, in welchen das Metall Kupfer ist, das mit β-Diketonaten ausgewählt aus der Gruppe umfassend β-Diketonaten mit 5 bis 11 C-Atomen und β-Diketonaten mit 5 bis 11 C-Atomen, substituiert durch 1 bis 18 Halogenatome, vorzugsweise substituiert durch 1 bis 6 Fluoratome, komplexiert ist.

5. Verfahren nach Anspruch 1, dadurch gekennzeichnet, daß man als metallorganische Verbindungen durch organische Reste substituierte Molybdän- oder Wolfram-Carbonyle einsetzt.

6. Verfahren nach einem der vorhergehenden Ansprüche, dadurch gekennzeichnet, daß man anodisch abscheidet.

7. Verfahren nach einem der Ansprüche 1 bis 5, dadurch gekennzeichnet, daß man kathodisch abscheidet.

8. Verfahren nach Anspruch 7, dadurch gekennzeichnet, daß man kathodisch auf Substrate aus organischen Polymeren abscheidet.

9. Verfahren nach einem der vorhergehenden Ansprüche, dadurch gekennzeichnet, daß die Substrattemperatur und/oder Wandtemperatur mindestens 5 °C, vorzugsweise 5 bis 25 °C höher ist als die Temperatur der in die Gas- oder Dampfphase zu überführenden metallorganischen Verbindung im Verdampfer.

10. Verfahren nach einem der vorhergehenden Ansprüche, dadurch gekennzeichnet, daß die Substrattemperatur im Bereich von Raumtemperatur bis 120 °C liegt.

11. Verfahren nach Anspruch 1, dadurch gekennzeichnet, daß man ein kapazitiv eingekoppeltes RF-Plasma einsetzt.

12. Metallschicht einer Dicke von 200 bis 2000 nm und einem spezifischen Widerstand von maximal 200 % des Bulkmaterials, erhältlich nach dem Verfahren der Ansprüche 1 bis 10.

13. Verbundkörper aus Polymer, gegebenenfalls einer oder mehreren Zwischenschichten und einer Metallschicht einer Dicke von 200 bis 2000 nm und einem spezifischen Widerstand von maximal 200 % des Bulkmaterials, erhältlich nach dem Verfahren der Ansprüche 1 bis 11.

14. Verbundkörper aus Polymer, gegebenenfalls einer oder mehreren Zwischenschichten und einer metallischen Leiterbahn, dadurch erhältlich, daß man eine erste Metallschicht nach einem Verfahren der Ansprüche 1 bis 11 abscheidet, eine Deckschicht aufbringt, die Deckschicht photolithographisch strukturiert, eine zweite, die Leiterbahn bildende Metallschicht galvanisch auf der ersten Deckschicht abscheidet und dann die Deckschicht und die hierbei freigelegte erste Metallschicht entfernt.

15. Verbundkörper nach Anspruch 13, dadurch gekennzeichnet, daß die erste Metallschicht eine Wolfram-, Molybdän- oder Kupferschicht ist, die Abscheidung der ersten Metallschicht kathodisch erfolgt, die zweite Metallschicht eine Kupfer-Leiterbahn ist, und das Verhältnis von Höhe zu Breite der Leiterbahn größer als 1 ist.

16. Verbundkörper nach Anspruch 14, gekennzeichnet durch eine Breite der Leiterbahn von maximal 50 nm.

17. Verfahren zur Optimierung der Abscheidung von metallenthaltenden Schichten mit einem spezifischen Widerstand, der maximal 200 % des spezifischen elektrischen Widerstands des Bulkmaterials beträgt, unter Zersetzung einer metallorganischen Verbindung in wasserstoffhaltiger Gas- oder Dampfphase mittels eines Plasmas, wobei man bezüglich der Energiedichte des Plasmas unter Bedingungen arbeitet, die wie folgt ermittelt werden können:
a) Man führt die Zersetzung bei einer Energiedichte des Plasmas durch, die mindestens so hoch ist, daß Liganden der zu zersetzenden metallorganischen Verbindung in Fragmente zerschlagen werden.
b) Man mißt das OES-Spektrum und bestimmt Peaks, die nicht auf ein Fragment des Liganden (Nicht-Ligandenfragment) zurück zuführen sind sowie solche, die auf ein bestimmtes Fragment des Liganden zurückzuführen sind.
c) Man optimiert den spezifischen Widerstand der abgeschiedenen Schicht durch Verringerung der in a) eingestellten hohen Energiedichte, bis im OES-Spektrum ein nicht dem Liganden zugeordneter Peak (Nicht-Ligandenfragment) und der dem Fragment des Liganden zugeordnete Peak ein solches Mindestverhältnis aufweisen, welches den gewünschten Anforderungen an die Leitfähigkeit der abgeschiedenen Schicht entspricht.
